# EUROPEAN PATENT APPLICATION

(11) **EP 2 481 546 A1**
(43) Date of publication of application: **01.08.2012**
(21) Application number: 10818709.7
(22) Date of filing: 13.09.2010
(51) Int. Cl.: B29C 33/68, B29C 45/26

(54) **MOLD RELEASE FILM, AND METHOD FOR MANUFACTURING LIGHT EMITTING DIODE**

(30) Priority: 24.09.2009 JP 2009218920
(71) Applicant: Asahi Glass Company, Limited, Tokyo 100-8405 (JP)
(72) Inventor: OKUYA, Tamao, Tokyo 100-8405 (JP)
(74) Representative: Müller-Boré & Partner Patentanwälte
(86) International application number: PCT/JP2010/065760
(87) International publication number: WO 2011/037034

(57) **Abstract**

To provide a mold release film for producing a light emitting diode by a mold, which is less susceptible to formation of pin holes or rupture and which is applicable to mass production of a light emitting diode by means of a mold having a plurality of cavities, and a process for producing a light emitting diode by means of such a mold release film. A mold release film to be disposed on the cavity surface of a mold to form a substantially hemispherical lens portion by encapsulating a light emitting element of a light emitting diode with an encapsulation resin, which release film has a thickness of from 16 to 175 µm and a tensile rupture elongation of from 600 to 3,000% at 110°C as measured in accordance with JIS K7127, and a process for producing a light emitting diode by means of such a mold release film.

## Description

### TECHNICAL FIELD

The present invention relates to a mold release film and a process for producing a light emitting diode.

### BACKGROUND ART

Light emitting diodes are used for various illuminations, signboards, backlights for liquid display panels, tail lamps for automobiles, etc., since high luminance is thereby obtainable at a low electric power, and they have a long useful life. In a light emitting diode, an N-type semiconductor and a P-type semiconductor are bonded, so that at the interface, electrons recombine with electron holes to generate energy thereby to emit light. By a light emitting diode, the power consumption is low at a level of about 1/2 as compared with a fluorescent lamp, and its useful life is said to be semipermanent from its structure, and yet, it does not contain a hazardous substance such as mercury, and its heat generation is less. Thus, it has attracted attention as an energy saving type, highly reliable light source presenting little environmental load.

The emission from a light emitting element of a light emitting diode is a point emission, whereby light is emitted in all directions. Therefore, for the purpose of improving the front luminance by aligning directions of light emitted from a light-emitting element to the front direction of the light emitting diode, a substantially hemispherical or cannonball-type lens portion is formed in the light-emitting diode in many cases. Further, the lens portion is required to have a function to impart an electrical insulating property to the light emitting element and to protect the light emitting element from an external environment of humidity, water, etc. Therefore, the lens portion is formed by encapsulation with a transparent encapsulation resin excellent in heat resistance with little attenuation of light. As such an encapsulation resin, a thermosetting resin such as a silicone resin or an epoxy resin, may, for example, be used.

A method for producing a light emitting diode may, for example, be a method of forming a lens portion (resin-encapsulated portion) by means of a compression molding method or a transfer molding method. That is, a method may be mentioned wherein a substrate having a light-emitting element mounted, is disposed so that the light-emitting element is located at a prescribed position in the encapsulation resin-molding portion (hereinafter referred to as the "cavity") of a mold, and an encapsulation resin is packed in the cavity to form the lens portion. Such a production method is excellent in productivity. However, in the production of a light emitting diode by such a molding method, a mold is used, and in a case where the lens portion is hardly releasable from the mold, if the light emitting diode is forcibly released, the lens portion may be damaged or cracked, thus leading to deterioration in the yield.

The following methods (i) and (ii) may be mentioned as methods to solve the above problem.
(i) In a step of encapsulation of a light-emitting element, a method of adding an internal release agent to the encapsulation resin (e.g. Patent Document 1).
(ii) A method wherein in such a state that the cavity surface of a mold is covered by a mold release film, an encapsulation resin is packed in the cavity to form a lens portion, whereupon the lens portion is released from the mold release film (e.g. Patent Document 2). In such a method, the lens portion is formed in such a state that the mold release film is adsorbed on the cavity surface, as stretched and deformed by vacuum suctioning so that it follows the cavity shape of the mold.

### PRIOR ART DOCUMENTS

### PATENT DOCUMENTS

Patent Document 1: Japanese Patent No. 2,523,512
Patent Document 2: JP-A-2008-114428

### DISCLOSURE OF INVENTION

### TECHNICAL SOLUTION

The method (i) has such a problem that by the addition of the release agent, the transparency of the encapsulation resin tends to be impaired, thus leading to deterioration of the luminance of the light emitting diode. The method (ii) is free from a problem of deterioration in the luminance of the light emitting diode, since there is no possibility that the transparency of the encapsulation resin is impaired by a release agent. However, the method (ii) has the following problem.

In the method (ii), the mold release film is three dimensionally deformed in order to let the mold release film follow the cavity in a shape corresponding to a substantially hemispherical (substantially hemispherical type or cannonball type) lens portion. Therefore, depending upon the shape of the lens portion to be formed i.e. depending upon the shape of the cavity, the mold release film is substantially deformed, whereby pinholes are likely to be formed in the mold release film, or the film is likely to be partially ruptured. If such pinholes or rupture results in the mold release film, a vaporized encapsulation resin component or the encapsulation resin itself may attach to the cavity surface of the mold at such a portion. In such a case, due to an influence of e.g. the resin component attached to the mold, deformation is likely to result in the lens portion of the obtainable light-emitting diode, thus leading to deterioration in the yield. Further, in order to solve such a problem, a step of cleaning e.g. the encapsulation resin attached to the mold or a step of dismounting the mold from and remounting the mold on the production apparatus, is required, whereby the production cost tends to increase.

Further, in recent years, in order to produce a large amount of light emitting diodes at once at a low cost, a lamp-sum molding by means of a mold having many cavities formed with narrow spaces, is increasing. In the case of such a mold having a complicated shape, the possibility of forming pinholes or rupture in the mold release film increases.

It is an object of the present invention to provide a mold release film for producing a light emitting diode by means of a mold, which is less susceptible to formation of pinholes or rupture and which is applicable also to mass production of light emitting diodes by means of a mold having a plurality of cavities.

Further, it is an object of the present invention to provide a process for producing a light emitting diode of good quality constantly by using the above mold release film.

### SOLUTION TO PROBLEM

In order to solve the above problem, the present invention has adopted the following constructions.
[1] A mold release film to be disposed on the cavity surface of a mold to form a substantially hemispherical lens portion by encapsulating a light emitting element of a light emitting diode with an encapsulation resin, which release film has a thickness of from 16 to 175 µm and a tensile rupture elongation of from 600 to 3,000% at 110°C as measured in accordance with JIS K7127.
[2] The mold release film according to the above [1], which is a film made of a fluororesin.
[3] The mold release film according to the above [2], wherein the fluororesin is an ethylene/tetrafluoroethylene copolymer.
[4] The mold release film according to the above [3], wherein the ethylene/tetrafluoroethylene copolymer is a copolymer of ethylene, tetrafluoroethylene and (perfluorobutyl)ethylene.
[5] The mold release film according to any one of the above [1] to [4], wherein the substantially hemispherical lens portion is a cannonball-type lens portion, and the diameter of the hemispherical portion of the lens portion is from 0.2 to 5 mm.
[6] A process for producing a light emitting diode by encapsulating a light emitting element with an encapsulation resin by means of a mold, which process comprises the following steps (a) to (e):
   (a) a step of disposing the mold release film as defined in any one of the above [1] to [5] to cover a mold cavity,
   (b) a step of vacuum-suctioning the mold release film to the mold cavity surface side,
   (c) a step of disposing a light emitting element at a prescribed position in the cavity,
   (d) a step of packing an encapsulation resin in the cavity to encapsulate the light emitting element with the encapsulation resin to obtain a light emitting diode, and
   (e) a step of taking out the light emitting diode from the mold.

### ADVANTAGEOUS EFFECTS OF INVENTION

The mold release film of the present invention is a mold release film for producing a light emitting diode by means of a mold, which is less susceptible to formation of pinholes or rupture. Therefore, it is suitable for use also for the mass production of light emitting diodes by means of a mold having a plurality of cavities.

Further, by the process of the present invention, it is possible to produce a light emitting diode of good quality constantly.

### BRIEF DESCRIPTION OF DRAWINGS

Figs. 1 (A) and (B) are schematic front views illustrating examples of the light-emitting diode in the present invention. (A) represents a hemispherical type, and (B) represents a cannonball type.
Fig. 2 is a cross sectional view illustrating an example of the mold in the present invention.
Fig. 3 is a cross sectional view illustrating one step in the process for producing a light emitting diode of the present invention.
Fig. 4 is a cross sectional view illustrating one step of the process for producing a light emitting diode of the present invention.
Fig. 5 is a cross sectional view illustrating one step of the process for producing a light emitting diode of the present invention.
Fig. 6 is a cross sectional view illustrating one step of the process for producing a light emitting diode of the present invention.
Fig. 7 is a cross sectional view illustrating one step of the process for producing a light emitting diode of the present invention.
Fig. 8 is a cross sectional view illustrating one step of the process for producing a light emitting diode of the present invention.

### DESCRIPTION OF EMBODIMENTS

### <Mold release film>

The mold release film of the present invention (hereinafter referred to as the "present mold release film") is a mold release film to be disposed on the cavity surface of a mold to form a substantially hemispherical lens portion by encapsulating a light emitting element of a light emitting diode with an encapsulation resin. That is, the present mold release film is a film to increase the releasing property of the obtained light emitting diode from the mold, as it is disposed to cover the cavity surface of a mold having a cavity of a shape corresponding to the shape of the lens portion of the light emitting diode during the production of the lens portion and positioned between the formed lens portion and the cavity surface.

The present mold release film is required to have a release property, surface smoothness, heat resistance durable against a temperature of from 110 to 140°C being the temperature of the mold during molding, and strength durable against the pressure or fluidity of the encapsulation resin.

From the view point of the release property, heat resistance, strength and elongation at a high temperature, the present mold release film is preferably a film made of at least one resin selected from the group consisting of a polyolefin and a fluororesin, more preferably a film made of a fluororesin. The present mold release film may be a film prepared by using a fluororesin and a non-fluorinated resin in combination, or may be a film having inorganic additives, organic additives, etc. incorporated.

The polyolefin is preferably polymethylpentene from the viewpoint of the release property and the mold-following property. As the polyolefin, one type may be used alone or two or more types may be used in combination.

The fluororesin may, for example, be an ethylene/tetrafluoroethylene copolymer (hereinafter referred to as "ETFE"), polytetrafluoroethylene or a perfluoro(alkyl vinyl ether)/tetrafluoroethylene copolymer. Among them, ETFE is particularly preferred from such a viewpoint that the elongation is large at a high temperature. As the fluororesin, one type may be used alone, or two or more types may be used in combination.

In ETFE, the content ratio of repeating units derived from tetrafluoroethylene (hereinafter referred to as "TFE") to repeating units derived from ethylene (hereinafter referred to as "E") (i.e. TFE/E), is preferably from 80/20 to 40/60, more preferably from 70/30 to 45/55, particularly preferably from 65/35 to 50/50, by molar ratio. When the content ratio of TFE/E is within the above range, ETFE is excellent in the heat resistance and mechanical properties.

ETFE may contain, in addition to repeating units derived from E and repeating units derived from TFE, repeating units derived from other monomers. Specific examples of such other monomers may, for example, be the following monomers (a1) to (a5) containing fluorine.

Monomer (a1): A fluoroolefin having at most 3 carbon atoms.

Monomer (a2): A polyfluoroalkylethylene represented by the formula X(CF₂)ₙCY=CH₂ (wherein each of X and Y which are independent of each other, a hydrogen atom or a fluorine atom, and n is an integer of from 2 to 8).

Monomer (a3): A fluorovinyl ether.

Monomer (a4): A fluorovinyl ether containing a functional group.

Monomer (a5): A fluorinated monomer having an alicyclic structure.

Monomer (a1) may, for example, be a fluoroethylene such as trifluoroethylene, vinylidene fluoride, vinyl fluoride or chlorotrifluoroethylene, hexafluoropropylene (hereinafter referred to as "HFP") or 2-hydropentafluoropropylene.

Monomer (a2) is preferably a monomer wherein n is from 2 to 6, more preferably a monomer wherein n is from 2 to 4. Specific examples include, for example, CF₃CF₂CH=CH₂, CF₃CF₂CF₂CF₂CH=CH₂ ((perfluorobutyl)ethylene, hereinafter referred to as "PFBE"), CF₃CF₂CF₂CF₂CF=CH₂, CF₂HCF₂CF₂CF=CH₂, CF₂HCF₂CF₂CF₂CF=CH₂, etc.

Monomer (a3) may, for example, be perfluoro(methyl vinyl ether), perfluoro(ethyl vinyl ether), perfluoro(polyvinyl ether) (hereinafter referred to as "PPVE"), CF₂=CFOCF₂CF(CF₃)O(CF₂)₂CF₃, CF₂=CFO(CF₂)₃O(CF₂)₂CF₃, CF₂=CFO(CF₂CF(CF₃)O)₂(CF₂)₂CF₃, CF₂=CFOCF₂CF(CF₃)O(CF₂)₂CF₃, CF₂=CFOCF₂CF=CF₂ or CF₂=CFO(CF₂)₂CF=CF₂.

Monomer (a4) may, for example, be CF₂=CFO(CF₂)₃CO₂CH₃, CF₂=CFOCF₂CF(CF₃)O(CF₃)₃CO₂CH₃, or CF₂=CFOCF₂CF(CF₃)O(CF₂)SO₂F.

Monomer (a5) may, for example, be perfluoro(2,2-dimethyl-1,3-dioxol), 2,2,4-trifluoro-5-trifluoromethoxy-1,3-dioxol, or perfluoro(2-methylene-4-methyl-1,3-dioxolane).

Further, other monomers may, for example, be the following monomers (b1) to (b4) containing no fluorine.

Monomer (b1): Olefin

Monomer (b2): Vinyl ester

Monomer (b3): Vinyl ether

Monomer (b4): Acid anhydride

Monomer (b1) may, for example, be propylene or isobutene.

Monomer (b2) may, for example, be vinyl acetate.

Monomer (b3) may, for example, be ethyl vinyl ether, butyl vinyl ether, cyclohexyl vinyl ether or hydroxybutyl vinyl ether.

Monomer (b4) may, for example, be maleic anhydride, itaconic anhydride, citraconic anhydride or himic anhydride (5-norbornene-2,3-dicarboxylic acid anhydride).

As such other monomers, one type may be used alone, or two or more types may be used in combination.

In ETFE, other monomers are preferably monomer (a2), HFP, PPVE and vinyl acetate, more preferably HFP, PPVE, CF₃CF₂CH=CH₂ and PFBE, most preferably PFBE.

In a case where ETFE contains repeating units derived from other monomers, the content of such other monomers to 100 mol% of all monomers is preferably from 0.01 to 20 mol%, more preferably from 0.10 to 15 mol%, particularly preferably from 0.20 to 10 mol%. When such other monomers are within such a range, ETFE is excellent in heat resistance and mechanical properties.

In a case where ETFE contains repeating units derived from PFBE, the content of PFBE to 100 mol% of all monomers is preferably from 0.10 to 15 mol%, more preferably from 0.20 to 10 mol%, particularly preferably from 0.30 to 5 mol%. When the content of PFBE is within such a range, ETFE is excellent in heat resistance and mechanical properties.

As the resin constituting the mold release film, among ETFE, a copolymer of E, TFE and PFBE (hereinafter referred to as "PFBE-containing ETFE") is particularly preferred.

The melt flow rate (MFR) of ETFE to be used in the present invention is preferably from 2 to 40 g/10 min, more preferably from 5 to 30 g/10 min, particularly preferably from 10 to 20 g/10 min. When MFR of ETFE is in such a range, the formability of ETFE is improved, whereby the mechanical properties of the present mold release film will be improved.

The above MFR is a value to be measured in accordance with ASTM D3159 at 297°C by using a load of 5 kg.

The thickness of the present mold release film is from 16 to 175 µm, preferably from 16 to 150 µm, more preferably from 26 to 150 µm, further preferably from 50 to 100 µm. When the thickness is at least 16 µm, it is possible to prevent formation of pinholes or rupture in the film. When the thickness is at most 175 µm, the present mold release film can easily be deformed, and the property to follow the cavity shape of the mold is improved, whereby the present mold release film can be securely in contact with the cavity surface, and a light emitting diode of good quality can constantly be produced.

Further, as the cavity of the mold is larger, the thickness of the present mold release film is preferably thin within the above mentioned range. Further, as the mold is more complicated having many cavities, the film thickness is preferably thin within the above mentioned range.

The tensile rupture elongation of the present mold release film at 110°C is from 600 to 3,000%, preferably from 620 to 2,000%, more preferably from 640 to 1,500%. When the tensile rupture elongation is at least 600%, the present mold release film can easily be deformed, and the property to follow the cavity shape of the mold is improved, whereby it is possible to prevent formation of pinholes or partial rupture in the present mold release film. When the tensile rupture elongation is at most 3,000%, it is possible to prevent the thickness of an elongated portion in the present mold release film from becoming too thin and to prevent a substantial nonuniformity in thickness in the film covering the cavity surface of the mold. Therefore, it is possible to constantly produce a light emitting diode having a lens portion with a good shape and showing excellent optical properties.

The tensile rupture elongation is measured by carrying out a tensile test with respect to a test film having a thickness of 50 µm under conditions of a temperature of 110°C and a tensile speed of 50 mm/min by a method in accordance with JIS K7127.

The tensile rupture elongation of the present mold release film can be adjusted by adjusting the molecular weight and the crystallinity of the resin. Specifically, the higher the molecular weight of the resin is, the higher the tensile rupture elongation becomes. Further, the lower the crystallinity of the resin is, the higher the tensile rupture elongation becomes.

The surface of the present mold release film is preferably smooth, by using the present mold release film having a smooth surface, a lens portion of high quality can easily be formed, and it becomes easy to produce a light emitting diode excellent in the optical properties.

If one surface of the film is made to have pearskin finish, and the film is used so that such a surface is on the mold cavity side, vacuum suctioning of the film to the cavity becomes easy, but use of such a film is likely to cause a deformation of the lens portion thereby to deteriorate the lens precision.

Specifically, the ten point mean roughness (Rz) of the surface of the present mold release film is preferably from 0.01 to 0.1 µm in the case of a mirror surface.

In the case of a pearskin finish surface, Rz is preferably from 0.15 to 3.5 µm. When Rz is at least 0.15 µm, the vacuum suctioning of the present mold release film to the cavity is accelerated. And, when Rz is at most 3.5 µm, it is easy to prevent formation of irregularities on the lens surface of a light emitting diode.

Rz is a value to be measured in accordance with JIS B0601.

The present mold release film can be produced by e.g. a melt process by means of an extruder provided with a T-die having a prescribed lip width by using a resin having the above mentioned composition.

The present mold release film as described above is used at the time of producing a light emitting diode having a substantially hemispherical lens portion by means of a mold. In the present invention, the substantially hemispherical lens portion includes a substantially hemispherical type lens portion and a cannonball type lens portion. The cannonball type lens portion is a lens portion of a shape consisting of a columnar form resin-encapsulated portion and a substantially hemispherical lens portion thereon.

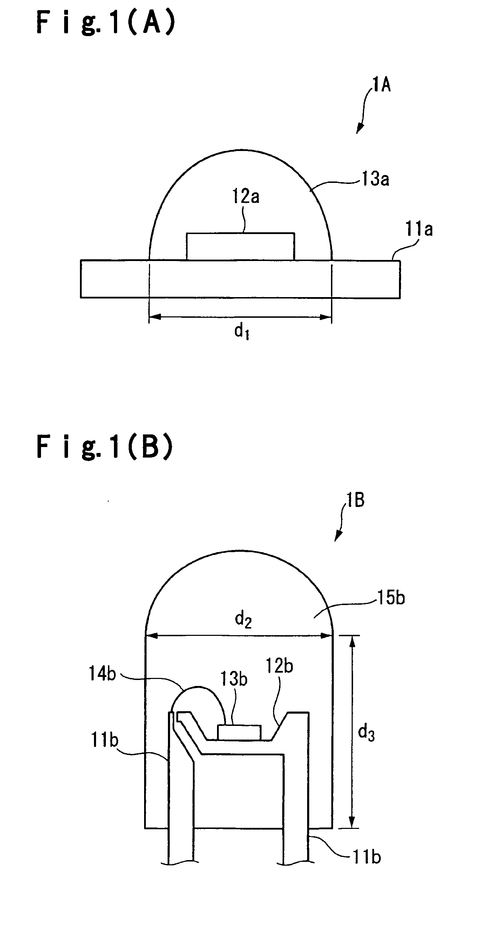

Fig. 1(A) illustrates an example of the light emitting diode having a substantially hemispherical type lens portion. Whereas, Fig. 1(B) illustrates an example of the light emitting diode having a cannonball type lens portion.

As shown in Fig. 1(A), in the light emitting diode 1A, a light emitting element 12a is mounted on a substrate 11a, and the light emitting element 12a is encapsulated with an encapsulation resin to form a substantially semispherical type lens potion 13a. In a case where the light emitting diode 1A is made to be a white emitting diode, in such a state that the light emitting element 12a is sealed with a resin having a phosphor dispersed therein, the circumference thereof is encapsulated with an encapsulation resin to form a lens portion 13a.

The diameter d₁ of the lens portion 13a is preferably from 0.1 to 30 mm, more preferably from 0.5 to 20 mm.

As shown in Fig. 1(B), in the light emitting diode 1B, a light emitting element 13b is set in a cup 12b formed integrally with a lead frame 11 b, and the light emitting element 13b and the other lead frame 11 b are connected by a Au wire 14b, and the circumference thereof is encapsulated with an encapsulation resin to form a cannonball type lens portion 15b. In a case where the light emitting diode 1 B is made to be a white emitting diode, in such a state that the light emitting element 13b is sealed by packing a resin having a phosphor dispersed therein in the cup 12b, the circumference thereof is encapsulated by an encapsulation resin to form a lens portion 15b.

The diameter d₂ of the hemispherical portion of the lens portion 15b is preferably from 0.2 to 5 mm, more preferably from 0.5 to 3 mm. The height d₃ of the columnar portion of the lens portion 15b is preferably from 0.2 to 8 mm, more preferably from 0.3 to 6 mm.

In the production of a light emitting diode having the above described substantially hemispherical type or cannonball type lens portion, the present mold release film deforms along the cavity of a shape corresponding to the shape of the lens portion without forming pinholes or rupture and can be closely in contact with the cavity surface. Therefore, a light emitting diode of good quality can be produced constantly.

### <Process for producing light emitting diode>

The process for producing a light emitting diode of the present invention is characterized in that the present mold release film is employed in a process for producing a light emitting diode by encapsulating a light emitting element with an encapsulation resin by means of a mold. For the process for producing a light emitting diode of the present invention, a known production process may be used except that the present mold release film is employed.

A method for forming the lens portion may be a compression molding method or a transfer molding method. As the production apparatus (mold), a known compression molding apparatus or transfer molding apparatus may be used. Also with respect to the production conditions, the same conditions as conditions in a known process for producing a light emitting diode may be used.

The process for producing a light emitting diode of the present invention comprises the following steps (a) to (e):
(a) a step of disposing the mold release film to cover a mold cavity,
(b) a step of vacuum-suctioning the mold release film to the mold cavity surface side,
(c) a step of disposing a light emitting element at a prescribed position in the cavity,
(d) a step of packing an encapsulation resin in the cavity to encapsulate the light emitting element with the encapsulation resin to obtain a light emitting diode, and
(e) a step of taking out the light emitting diode from the mold.

Now, as an embodiment of the process for producing a light emitting diode of the present invention, a case will be described in detail wherein the above-mentioned light emitting diode 1A is produced by a transfer molding method.

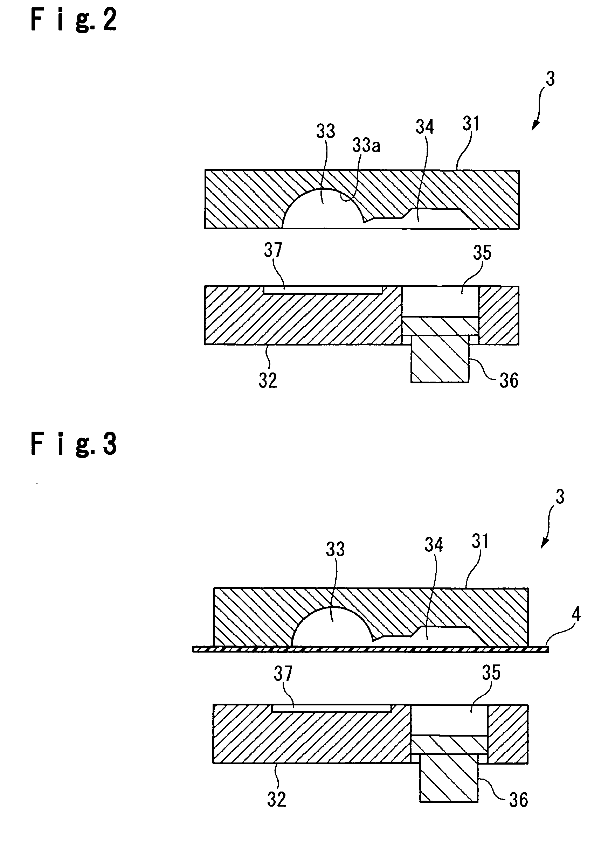

The mold 3 to be used has an upper die 31 and a lower die 32, as shown in Fig. 2.

On the upper die 31 side, a cavity 33 of a shape corresponding to the shape of the lens portion 13a of the light emitting diode 1A, and a concave resin-introducing portion 34 to introduce an encapsulation resin into the cavity 33, are formed.

On the lower die 32 side, as shown in Fig. 2, a resin-placing portion 35 to place the encapsulation resin is formed, and in the resin-placing portion 35, a plunger 36 to push the encapsulation resin out to the upper die 31 is installed.

The cavity surface 33a of the upper die 31 is preferably smooth, since a lens portion of high quality can thereby easily be formed, and a light emitting diode excellent in optical properties can easily be obtainable.

If the cavity surface 33a is made to be pearskin finish, the present mold release film can more efficiently be vacuum-suctioned to the cavity surface 33a, but a deformation is likely to be formed on the lens portion 13a of the obtainable light emitting diode 1A, whereby the lens precision is likely to be deteriorated.

### Step (a):

As shown in Fig. 3, the present mold release film 4 is disposed to cover the cavity 33 of the upper die 31 of the mold 3. The present mold release film 4 is preferably disposed to cover the entirety of the cavity 33 and the resin-introducing portion 34.

### Step (b):

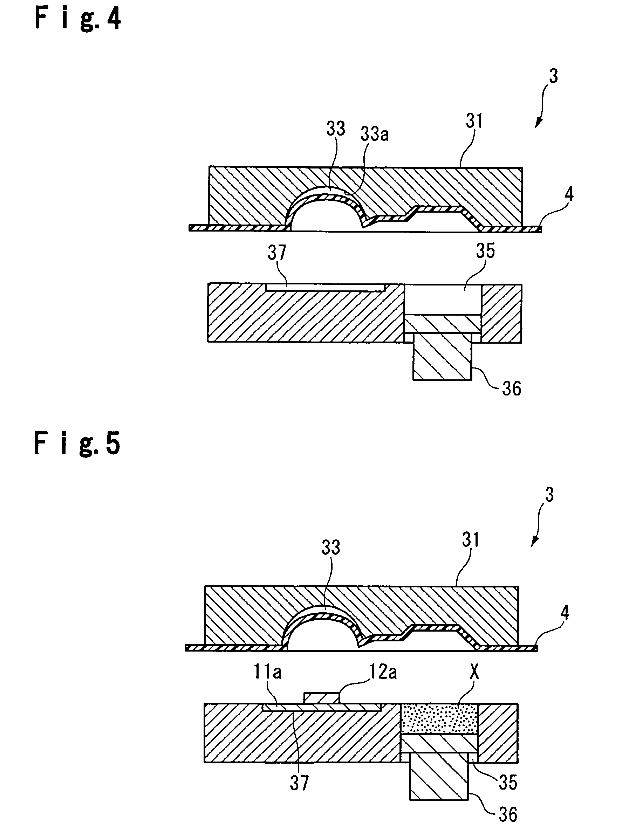

By vacuum suctioning via a groove formed outside of the cavity 33 in the mold 3, a space between the present mold release film 4, and the cavity 33 and the resin-introducing portion 34, is vacuumed, so that, as shown in Fig. 4, the present mold release film 4 is stretched and deformed, and vacuum-adsorbed on the upper die 31 of the mold 3.

Depending upon the strength or thickness of the mold release film 4 under the high temperature environment or the shape of the cavity 33, the mold release film 4 may not necessarily be closely in contact with the cavity 33. As shown in Fig. 4, at the stage of vacuum suctioning in the step (b) in this embodiment, the present mold release film 4 is not completely in contact with the cavity surface 33a.

### Step (c):

As shown in Fig. 5, a substrate 11 a having a light emitting element 12a mounted thereon, is set on a substrate-placing portion 37, and the mold 3 is closed to dispose the light emitting element 12a at a prescribed position in the cavity 33. Further, an encapsulation resin X is placed on the plunger 36 of the resin placing portion 35.

As the encapsulation resin X, a transparent resin is usually used to encapsulate the light emitting element of a light emitting diode. Otherwise, a milky white transparent resin having an additive, etc. incorporated for the purpose of light diffusion property, may be used.

As such an encapsulation resin X, a thermosetting resin such as a silicone resin (tradename "LPS-3412A" or "LPS-3412B" (manufactured by Shin-Etsu Chemical Co., Ltd.), or the like) or an epoxy resin (SEJ-01 R, manufactured by Nippon Kayaku Co., Ltd.), or the like, is preferred.

### Step (d):

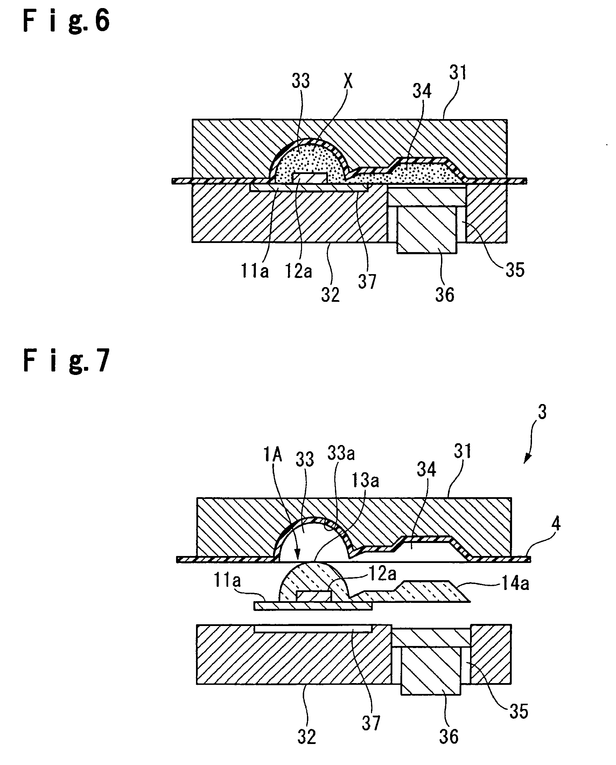

As shown in Fig. 6, the plunger 36 of the lower die 32 is pushed up to pack the encapsulation resin X in the cavity 33 via the resin-introducing portion 34. Then, the mold 3 is heated to cure the encapsulation resin X to form a lens portion 13a encapsulating the light emitting element 12a. In this embodiment, in the step (d), as the encapsulation resin X is packed in the cavity 33, by the resin pressure, the present mold release film 4 is further pushed towards the cavity surface 33a, stretched and deformed to be closely in contact with the cavity surface 33a. Therefore, a substantially hemispherical type lens portion 13a corresponding to the shape of the cavity 33 is formed.

The heating temperature of the mold 3 i.e. the temperature for heating the encapsulation resin X is preferably from 100 to 185°C, more preferably from 110 to 140°C. When the heating temperature is at least 100°C, the productivity of the light emitting diode is improved. When the heating temperature is at most 185°C, deterioration of the encapsulation resin X can easily be prevented. Further, in a case where it is particularly desired to protect the light emitting diode or to avoid a shape change of the lens portion 13a caused by the thermal expansion rate of the encapsulation resin X, it is preferred to carry out the heating at a temperature as low as possible within the above range.

The resin pressure at the time of packing the encapsulation resin X is preferably from 2 to 30 MPa, more preferably from 3 to 10 MPa. When the pressure is at least 2 MPa, it is easy to avoid a failure such as inadequate packing of the encapsulation resin X. When the pressure is at most 30 MPa, a light emitting diode of good quality can easily be obtainable. The resin pressure of the encapsulation resin X can be adjusted by the plunger 36.

### Step (e):

As shown in Fig. 7, the light emitting diode 1A is taken out from the mold 3, in such a state that a cured product 14a having the encapsulation resin X cured in the resin-introducing portion 34, is attached, and the cured product 14a is then cut off.

In the production process in this embodiment, in the mold 3 after forming the lens portion 13a, the present mold release film 4 is disposed between the formed lens portion 13a and the cavity surface 33a, whereby the light emitting diode 1A can easily be released from the mold 3.

In this embodiment, the order of the steps (a) and (b) and the step (c) is not particularly limited. For example, after disposing the substrate 11 a and the light emitting element 12a at the prescribed positions in the cavity (step (c)), the present mold release film 4 may be disposed on the cavity 33 of the mold 3 (step (a)), and the present mold release film 4 may be vacuum-suctioned to the cavity surface 33a side of the mold 3 (step (b)).

The process for producing a light emitting diode of the present invention is applicable also to the production of a light emitting diode having a cannonball type lens portion in the same manner as in the above described production of a light emitting diode having a substantially hemispherical type lens portion. In such a case, the above described steps (a) to (e) may be carried out by using a mold having a cavity corresponding to the cannonball type lens portion, wherein a light emitting element can be set at a prescribed position.

Further, it is also preferred to produce a light emitting diode of the present invention by a compression molding method by using the present mold release film. As disclosed in JP-A-2008-114428, the compression molding method is a method which is commonly employed for the production of a light emitting diode.

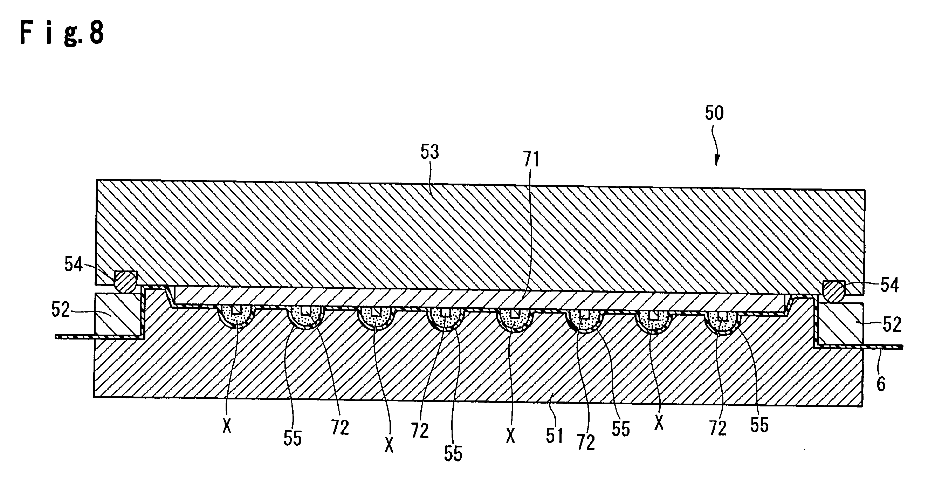

For example, as shown in Fig. 8, a method may be mentioned wherein a compression molding mold 50 is employed which comprises a lower die 51 having a plurality of cavities 55 (8 cavities in Fig. 8) of a shape corresponding to the shape of the lens portion of a light emitting diode, an intermediate die 52, an upper die 53 and an O-ring 54 located between the intermediate die 52 and the upper die 53 to shield external air.

### Step (a):

The present mold release film 6 is disposed to cover the respective cavities 55 of the lower die 51, so that it is fixed as sandwiched by the lower die 51 and the intermediate die 52.

### Step (b):

The present mold release film 6 is vacuum-contacted to the respective cavities 55 of the lower die 51.

### Steps (c) and (d):

Onto the cavities 55 of the lower die 51, a light transmissive liquid encapsulation resin X such as a silicone resin or an epoxy resin is supplied. Then, a substrate 71 (such as a lead frame) having a plurality of light emitting elements 72 (such as light emitting diode chips) mounted at positions corresponding to the respective cavities 55 is disposed on the upper die 53, whereupon the compression molding mold 50 is closed, and the desired number of light emitting elements are encapsulated at once by compression molding to produce light emitting diodes.

### Step (e):

The light emitting diodes are taken out from the compression molding mold 40.

According to the process of the present invention as described above, by using the present mold release film, it is possible to produce a light emitting diode of high quality having a substantially hemispherical lens portion constantly in good yield. Further, the present mold release film can easily be stretched and deformed without forming pinholes or rupture, whereby it is applicable also to a mold of a complex shape having a plurality of cavities. Therefore, it is also possible to produce a large amount of light emitting diodes at once at a low cost.

Further, the process for producing a light emitting diode of the present invention is not limited to the above described processes. For example, a mold may be employed wherein a vacuum suction perforation is provided in a cavity. By using such a mold, the present mold release film can be vacuum-contacted to the cavity surface efficiently as compared with the process using the above mold 3. However, a trace of the suction perforation is likely to be transferred via the mold release film to the lens portion of the light emitting diode, whereby the lens precision is likely to be inferior.

Now, the advantageous effects of the present mold release film will be described.

Heretofore, in a case where a lens portion is formed by means of a mold, even when a mold release film is used which is considered to have a sufficient tensile rupture elongation, pinholes or rupture has sometimes been formed in the film. For example, in a mold to form a substantially hemispherical type lens portion, the ratio of the length x of the circumference of the cross section (semicircle) containing the bottom of the cavity to the diameter y of the cavity (i.e. x:y) is π/2: (=-π:2r). Then, even at a portion on line passing through the bottom (the center) of the cavity, where the mold release film is stretched most, the stretching rate (elongation) of the mold release film is calculated to be about 160%. From such calculation, it is considered that if a mold release film having a tensile rupture elongation of 200% is employed, it is possible to produce a light emitting diode without formation of pinholes or rupture in the film.

However, from a detailed study on this point by the present inventor, it has been found that in the production of a substantially hemispherical light emitting diode, it is not possible to prevent formation of pinholes or rupture in the mold release film unless the tensile rupture elongation is at least 600%. The reason is considered to be as follows.

At the time of forming the lens portion, the mold release film is gradually brought in contact with the cavity surface from the edge side of the cavity of the mold towards the bottom of the cavity. At that time, the mold release film contacted to the mold tends to be less slippery as vacuum-contacted, and it is considered that in the mold release film, the portion closely contacted to the cavity surface will not be substantially stretched any longer. That is, it is considered that the mold release film in the cavity is stretched and deformed more towards the bottom of the cavity. Therefore, it is considered that pinholes or rupture is likely to be formed in the film unless a mold release film having a tensile rupture elongation far more than the tensile rupture elongation which is considered to be sufficient from the calculation, is employed. Actually, pinholes or rupture in the mold release film has been frequently observed in the vicinity of the bottom of the cavity, and such a fact supports this reasoning.

### EXAMPLES

Now, the present invention will be described in detail with reference to Examples and Comparative Examples. However, it should be understood that the present invention is by no means restricted by the following description.

### [Tensile rupture elongation]

The tensile rupture elongation (unit: %) of a mold release film was measured in accordance with JIS K7127. A mold release film having a thickness of 50 µm was punched out by a test specimen type 5 dumbbell to prepare a test film. With respect to the test film, a tensile test was carried out under the conditions of a temperature of 110°C and a tensile speed of 50 mm/min to measure the tensile rupture elongation.

### [Presence or absence of rupture or pinholes]

After the production of a light emitting diode, formation of pinholes or rupture in the mold release film was visually examined.

### [Property of mold release film to follow mold]

After the production of a light emitting diode, the property of the mold release film to follow a mold was visually evaluated by the following standards.
○ (good): No space was observed between the cavity surface and the film surface
× (no good): A space was observed between the cavity surface and the film surface.

### [Evaluation of the shape of lens portion]

The evaluation of the shape of a lens portion of the obtained light emitting diode was visually carried out by the following standards.
○(good): No local irregularities were observed.
× (no good): Local irregularities due to rupture of the mold release film were observed.

### EXAMPLE 1

### (Production of mold release film)

As a fluororesin, ETFE (MFR (in accordance with ASTM D3159, load: 5 kg, measuring temperature: 297°C): 15 g/10 min) was used which had a polymer composition of repeating units derived from TFE/repeating units derived from E/repeating units derived from PFBE=56.3/40.7/3.0 (molar ratio). By an extruder having a lip adjusted to have a thickness of 50 µm, the above ETFE was melt-extruded at 320°C to obtain a mold release film (ETFE film) having a thickness of 50 µm.

The tensile rupture elongation of the mold release film at 110°C was 680%.

### (Production of light emitting diode)

As a light emitting element, a white emitting element (operating voltage: 3.5 V, consumption current: 10 mA) was used. Further, as a mold, mold 3 exemplified in Fig. 2 was used. The shape of the cavity 33 was a shape corresponding to a substantially hemispherical type lens portion having a diameter of 0.7 mm.

The above mold release film was disposed to cover the cavity 33 of the mold 3. A substrate having the above white light emitting element mounted, was disposed on the lower die 32 so that the light emitting element was located at a position corresponding to the center (bottom) of the cavity 33. By vacuum suctioning, the mold-release film was vacuum-contacted to the upper die 31, and in the cavity 33, a transparent silicone resin (mixture of equivalent amounts of LPS-3412A and LPS-3412B (manufactured by Shin-Etsu Chemical Co., Ltd.)) was packed. The mold 3 was heated to cure the resin to form a substantially hemispherical type lens portion. The temperature for heating the mold was 110°C, and the pressure was 5 MPa. Further, the curing time was 5 minutes. Thereafter, a light emitting diode was taken out from the mold.

### EXAMPLE 2

A mold release film (ETFE film) having a thickness of 100 µm was obtained in the same manner as in Example 1 except that the lip was adjusted to have a thickness of 100 µm. Further, by using the mold release film, a light emitting diode was produced in the same manner as in Example 1.

### COMPARATIVE EXAMPLES 1 and 2

A mold release film (ETFE film) was obtained in the same manner as in Example 1 except that the lip was adjusted to have a thickness as shown in Table 1. Further, by using the mold release film, a light emitting diode was produced in the same manner as in Example 1.

### COMPARATIVE EXAMPLES 3 to 6

Using ETFE (MFR (in accordance with ASTM D3159, load: 5 kg, measuring temperature: 297°C): 11.5 g/10 min) having a polymer composition of repeating units derived from TFE/repeating units derived from E/repeating units derived from PFBE=52.3/46.4/1.3 (molar ratio), a mold release film was obtained in the same manner as in Example 1 except that the lip was adjusted to have a thickness shown in Table 1.

The tensile rupture elongation of the mold release film at 110°C was 550%.

By using the mold release film, a light emitting diode was produced in the same manner as in Example 1. The presence or absence of rupture or pinholes in the mold release film, evaluation of the property to follow a mold and evaluation of the shape of a lens portion in each of Examples and Comparative Examples are shown in Table 1.

**TABLE 1**

| | | Examples | | Comparative Examples | | | | | |
|---|---|---|---|---|---|---|---|---|---|
| | | 1 | 2 | 1 | 2 | 3 | 4 | 5 | 6 |
| Mold release film | Thickness [µm] | 50 | 100 | 12 | 200 | 25 | 50 | 100 | 200 |
| | Tensile rupture elongation | 680 | 680 | 680 | 680 | 550 | 550 | 550 | 550 |
| | Presence or absence of rupture or pinholes | Absent | Absent | Present | Absent | Present | Present | Present | Absent |
| | Property to follow mold | ○ | ○ | ○ | × | × | × | × | × |
| Light emitting diode | Shape of lens portion | ○ | ○ | ○ | × | × | × | × | × |

As shown in Table 1, in Examples 1 and 2, no pinholes or rupture was observed in the mold release film, and the property of the mold release film to follow the mold was also good. Further, a light emitting diode of high quality having a lens portion having a good shape, was produced.

On the other hand, in Comparative Example 1 in which a mold release film having a tensile rupture elongation equivalent to Examples but a thickness being thin, was used, pinholes or rupture was observed in the mold release film, and the property of the mold release film to follow the mold was inferior. Further, a light emitting diode of low quality wherein the shape of the lens portion was no good, was obtained.

Further, in Comparative Example 2 wherein a mold release film having a tensile rupture elongation equivalent to Examples, but a thickness being thick, was used, although no pinholes or rupture was observed in the mold release film, the property of the mold release film to follow the mold was inferior, and a light emitting diode of low quality wherein the shape of the lens portion was no good, was obtained.

Further, in Comparative Examples 3 to 5 wherein a mold release film having a tensile rupture elongation of 550% and a thickness of from 25 to 100 µm, was used, pinholes or rupture was observed in the mold release film, and the property of the mold release film to follow the mold was inferior. Further, a light emitting diode of low quality wherein the shape of the lens portion was no good, was obtained.

Further, in Comparative Example 6 in which a mold release film having a tensile rupture elongation of 550% and a thickness of 200 µm was used, although no pinholes or rupture was observed in the mold release film, the property of the mold release film to follow the mold was inferior, and a light emitting diode of low quality wherein the shape of the lens portion was no good, was obtained.

### INDUSTRIAL APPLICABILITY

The mold release film of the present invention is useful as a mold release film to be disposed in a cavity of a mold to form a lens encapsulating a light emitting element of a light emitting diode.

The entire disclosure of Japanese Patent Application No. 2009-218920 filed on September 24, 2009 including specification, claims, drawings and summary is incorporated herein by reference in its entirety.

### REFERENCE SYMBOLS

1A, 1B: Light emitting diode, 11a: substrate, 12a: light emitting element, 13a: lens portion, 11b: lead frame, 12b: cup, 13b: light emitting element, 14b: Au wire, 15b: lens portion, 3: mold, 31: upper die, 32: lower die, 33: cavity, 33a: cavity surface, 4: the present mold release film, 50: compression molding mold, 51: lower die, 52: intermediate die, 53: upper die, 54: O-ring, 55: cavity, 6: present mold release film, 71: substrate, 72: light emitting element

## Claims

1. A mold release film to be disposed on the cavity surface of a mold to form a substantially hemispherical lens portion by encapsulating a light emitting element of a light emitting diode with an encapsulation resin, which release film has a thickness of from 16 to 175 µm and a tensile rupture elongation of from 600 to 3,000% at 110°C as measured in accordance with JIS K7127.

2. The mold release film according to Claim 1, which is a film made of a fluororesin.

3. The mold release film according to Claim 2, wherein the fluororesin is an ethylene/tetrafluoroethylene copolymer.

4. The mold release film according to Claim 3, wherein the ethylene/tetrafluoroethylene copolymer is a copolymer of ethylene, tetrafluoroethylene and (perfluorobutyl)ethylene.

5. The mold release film according to any one of Claims 1 to 4, wherein the substantially hemispherical lens portion is a cannonball-type lens portion, and the diameter of the hemispherical portion of the lens portion is from 0.2 to 5 mm.

6. A process for producing a light emitting diode by encapsulating a light emitting element with an encapsulation resin by means of a mold, which process comprises the following steps (a) to (e):
(a) a step of disposing the mold release film as defined in any one of Claims 1 to 5 to cover a mold cavity,
(b) a step of vacuum-suctioning the mold release film to the mold cavity surface side,
(c) a step of disposing a light emitting element at a prescribed position in the cavity,
(d) a step of packing an encapsulation resin in the cavity to encapsulate the light emitting element with the encapsulation resin to obtain a light emitting diode, and
(e) a step of taking out the light emitting diode from the mold.
